# EUROPÄISCHE PATENTSCHRIFT

(11) **EP 0 417 341 B1**
(45) Veröffentlichungstag und Bekanntmachung des Hinweises auf die Patenterteilung: **02.03.1994**
(21) Anmeldenummer: 89116907.0
(22) Anmeldetag: 13.09.1989
(51) Int. Cl.: H01L 27/108

(54) **Kapazitätsstruktur für Feldeffekttransistor-Halbleiterspeicher**
Capacitor structure for field-effect transistor semiconductor memories
Structure de capacité pour mémoire à semi-conducteur du type FET

(43) Veröffentlichungstag der Anmeldung: 20.03.1991
(73) Patentinhaber: Deutsche ITT Industries GmbH, 79108 Freiburg (DE)
(72) Erfinder: Blossfeld, Lothar, Dipl.-Phys., D-7800 Freiburg-Hochdorf (DE)

(56) Entgegenhaltungen:
- DE-A- 3 311 401
- PROCEEDINGS OF THE INTERNATIONAL ELECTRON DEVICES MEETING, San Francisco, CA, 9.-12. Dezember 1984, Seiten 6-12, IEEE, New York, US; S. ASAI: "Trends in megabit DRAMS"
- IMB TECHNICAL DISCLOSURE BULLETIN, Band 19, Nr. 1, Juni 1976, Seite 145, New York, US; M. BRISKA and E. EISENBRAUN: "Small area/high epsilon capacitor in a dynamic memory cell"

## Beschreibung

Die Erfindung betrifft eine Kapazitätsstruktur für Feldeffekttransistor-Halbleiterspeicher, wie sie im Anspruch 1 beschrieben ist.

Die Verkleinerung der Halbleitergeometrien, wie sie derzeit allenthalben angestrebt wird, läßt sich im Bereich der Speicherbausteine nur dann sinnvoll weiterführen, wenn bei Verkleinerung der Flächen entsprechend große Kapazitäten erzeugt werden können.

Es hat sich gezeigt, daß Kapazitätswerte von mehr als 30 fF notwendig sind, um die Störsicherheit und Auswertbarkeit von DRAM-Zellen sicherzustellen.

Als Lösung dieses Problems dienen bei kleinen Speicherzellen die sogenannten Trenchkapazitäten, daß heißt, es werden Gräben im Halbleiterkörper geätzt, die mit einer dünnen Isolatorschicht entsprechend ausgekleidet werden, siehe "Bild der Wissenschaft" 7-1986, Seite 88. Daß ein solches Verfahren aufwendig ist, liegt auf der Hand.

Ein anderer Lösungsweg besteht darin, "stacked capacitors" herzustellen. Hierbei werden mehrere übereinander liegende, durch Isolierschichten getrennte leitende Schichten aus z.B. Polysilicium erzeugt, siehe hierzu EP-A-1 0 161 850. Auch das dafür erforderliche Verfahren ist umständlich und kostenintensiv.

Die Erfindung, wie sie in den Ansprüchen gekennzeichnet ist, löst somit die Aufgabe, eine Kapazitätsstruktur anzugeben, die besonders einfach und damit kostengünstig zu realisieren ist. Desweiteren soll ein Verfahren zur Herstellung einer derarigen Kapazitätsstruktur angegeben werden.

Die Grundidee der Erfindung besteht darin, die erforderliche Kapazität mit Hilfe eines Materials zu realisieren, das eine um mehrere Größenordnungen höhere Dielektrizitätskonstante besitzt, als in Verwendung befindliches Material wie z.B. SiO₂. Vorschläge in diese Richtung wurden schon gemacht. So ist z.B. aus IBM Technical Disclosure Bulletin Bd. 19, Nr. 1, Juli 1976, Seite 145 ein Verfahren bekannt, das die Erhöhung der Dielektrizitätskonstante des isolierenden Materials, üblicherweise SiO₂, beinhaltet, um bei kleinerer Kapazitätsfläche die gleiche Gesamtkapazität zu erreichen. Beim offenbarten Verfahren wird dies dadurch erreicht, daß innerhalb einer SiO₂-Schicht ein Kern aus Titanat oder einer Titan-Zirkon-Verbindung erzeugt wird, indem die Metalle in die SiO₂-Schicht implantiert, dann thermisch oxydiert und anschließend einen Anneal-Prozeß unterworfen werden. Dabei kommt es zur Kristallisation der Oxide innerhalb der SiO₂-Schichten. Um eine hinreichende Erhöhung der Kapazität zu erzielen, muß der Kern mindestens 30 % der Dicke der gesamten Isolationsschicht betragen. Ein solches Verfahren ist zwangsläufig mit hohem Aufwand verbunden.

Die Erfindung gibt dagegen eine Struktur an, die zwar auch keramisches Material als Kapazitätsbildner enthält, die sich im Rahmen der heute üblichen Prozeßschritte jedoch leicht auf einem Halbleiterchip integrieren läßt. Darüberhinaus wird im Verfahren zu deren Herstellung angegeben.

Der Erfindung wird nachstehend anhand dreier Figuren der Zeichnung näher erläutert, wobei jede Figur den nicht maßstabgetreuen Schnitt durch ein Ausführungsbeispiel der Erfindung darstellt. Gleiche Merkmale sind dabei mit gleichen Bezugszeichen versehen.

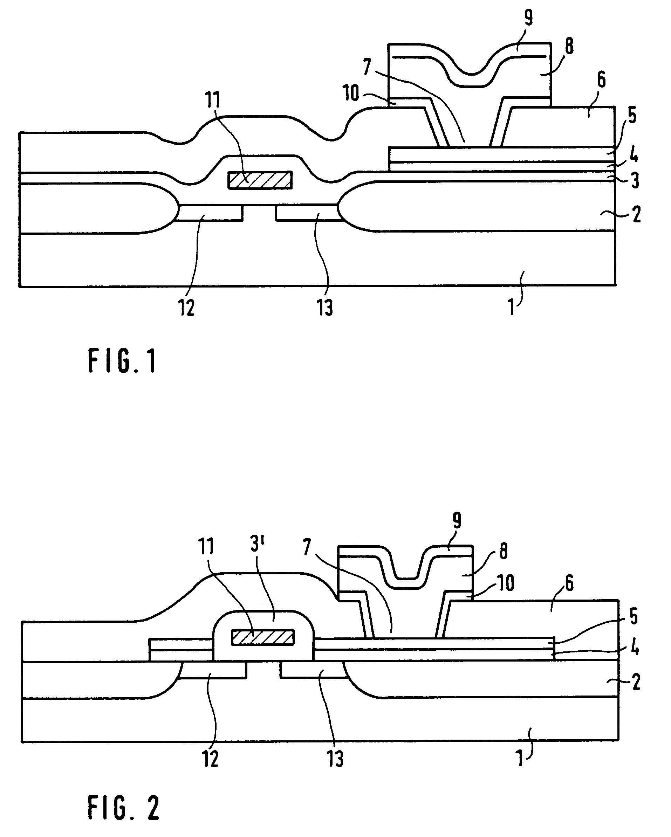

In Fig.1 ist der Halbleiterkörper 1 gezeigt, in dem die aktiven Zonen, Sourcezone 12 und Drainzone 13, im Abstand zueinander und von einer Feldoxidschicht 2 eingerahmt angeordnet sind. Über der Feldoxidschicht 2 und den beiden aktiven Zonen 12, 13 liegt eine erste Isolierschicht 3, in der an der üblichen Stelle oberhalb der aktiven Zonen 12, 13 die Gate-Elekrode 11, die gleichzeitig die Wortleitung darstellt, eingelassen ist. Im Abstand zur Drainzone 13 ist auf der Isolierschicht 3 über der Feldoxidschicht 2 eine Haftschicht 4 angeordnet, die selbst wiederum von einer Kontaktschicht 5 abgedeckt ist. Bis auf den Graben 7 ist die gesamte Oberfläche mit einer Passivierungsschicht 6 überzogen. Im Graben 7 sitzt das Dielektrikum 8 auf der Kontaktschicht 5 auf, wobei es durch eine Haftschicht 10 von der Passivierungsschicht 6 getrennt auf dieser überlappend aufliegt. Das Dielektrikum 8 wird von einer Elektrodenschicht 9 bedeckt. Aus Gründen der Übersicht sind die jeweiligen Anschlüsse der Gate-Elektrode 11, der aktiven Zonen 12, 13, sowie der Kontaktschicht 5 nicht gezeigt.

Die Herstellung der in Fig.1 gezeigten Struktur geschieht dabei beispielsweise wie folgt:
Ausgehend von einem Halbleitersubstrat 1 wird unter Anwendung herkömmlicher Verfahrensschritte eine Feldeffekttransistor-Struktur hergestellt, bestehend aus der Gate-Elektrode 11, den Source- und Drainzonen 12 und 13, der Feldoxidschicht 2 sowie der Isolierschicht 3.

Auf der Isolierschicht 3 aus z.B. Phosphorsilikatglas wird nun im Abstand zu einer der aktiven Zonen, im vorliegenden Fall der Drain-Zone 13, unter Anwendung üblicher Photolithographietechnik oberhalb der Feldoxidschicht 2 eine Doppelschicht aufgebracht, bestehend aus einer auf der Isolierschicht 3 aufliegenden Haftschicht 4 aus z.B. TiW, TiN, TiO₂ oder Ti und einer darüberliegenden Kontaktschicht 5 aus einem Material, das bis 1000° gegenüber Sauerstoffeinwirkung resistent ist, also sich nicht oder nur schwer oxidieren läßt, wie z.B. ein leitfähiges Oxid wie Indium-Zinn-Oxid oder ein Metall wie Pd oder Pt. Im nächsten Schritt wird die Oberfläche des Halbleiteraufbaus mit einer Passivierungsschicht 6 aus z.B. SiO₂ überzogen, die dann photolithographisch so strukturiert wird, daß in ihr im Bereich der Doppelschicht ein bis zur Kontaktschicht 5 reichender Graben 7 entsteht. Unter Anwendung bekannter Techniken werden die Wände des Grabens 7 sowie dessen Ränder mit einer zweiten Haftschicht 10 gleichen Materials wie das der Haftschicht 4 überzogen und im Anschluß daran das Dielektrikum 8 mit darüberliegender Elektrodenschicht 9 abgeschieden und unter Anwendung herkömmlicher Photolithographie- und Ätztechnik, wie z.B. RIE, die in Fig.1 gezeigte Struktur erzielt. Das Dielektrikum besteht dabei vorzugsweise aus Keramik, und zwar aus Blei-Zirkon-Titanat als Basismaterial, das z.B. mit Lanthan dotiert sein kann, während die Elektrodenschicht 9 aus dem Material der Kontaktschicht 5, vorzugsweise aus Pt besteht.

In einem letzten Schritt werden durch bekannte photolithographische Maßnahmen Kontakte in üblicher Weise mit den aktiven Bereichen des Bauelements und der Kontaktschicht 5 hergestellt.

Fig.2 zeigt eine weitere Ausbildungsform einer Kapazitätsstruktur nach der Erfindung. In dem Halbleiterkörper 1 ist eine die beiden aktiven Zonen, Source- und Drainzone, 12, 13, umgebende Feldoxidschicht 2 eingelassen. Auf der planarisierten Oberfläche des Halbleiterkörpers 1 liegt eine Doppelschicht aus der ersten Haftschicht 4 und der Kontaktschicht 5, die Teile der Feldoxidschicht 2 sowie die Source- und Drainzone 12, 13 abdeckt und lediglich im Bereich der Gate-Elektrode 11 unterbrochen ist, die an gewohnter Stelle in einer Isolierung 3 oberhalb der Source- und Drainzone liegt. Mit Ausnahme des Grabens 7, der oberhalb der Feldoxidschicht 2 liegt, ist die gesamte Oberfläche des Halbleiteraufbaus mit einer Passivierungsschicht 6 bedeckt. Die Wände und Ränder des Grabens 7 sind mit einer zweiten Haftschicht 10 überzogen, an der sich das Dielektrikum 8 anschließt, das selbst wiederum mit einer Elektrodenschicht 9 abgedeckt ist und bis auf die Kontaktschicht 5 reicht.

Die Herstellung der Struktur nach Fig.2 erfolgt unter Anwendung der schon bei der Fig.1 genannten herkömmlichen Verfahrensschritten und der dort beschriebenen Materialien.

Ausgehend von einem Halbleiterkörper 1 wird zunächst die Feldoxidschicht 2 und im Anschluß daran die Gate-Elektrode 11 erzeugt. Diese wird mit einer Isolierschicht 3' umhüllt, wobei bekannte Maßnahmen wie Spacertechnik und Planarisierung angewendet werden. Durch letztere wird gleichzeitig ein Planarisierungseffekt auf der Oberfläche des Halbleiterkörpers 1 erzielt. Nachdem Source- und Drainzonen 12, 13 auf herkömmliche Weise wie z.B. durch Ionenimplantation und Diffusion erzeugt worden sind, wird auf der Oberfläche des Halbleiterkörpers 1 mittels Photolithographietechnik eine Doppelschicht aus der auf dem Halbleiterkörper aufliegenden ersten Haftschicht 4 und der darauf angeordneten Kontaktschicht 5 erzeugt. Die Doppelschicht bedeckt dabei Teile der Feldoxidschicht 2 und an die Isolierung 3′ der Gate-Elektrode anstoßend die Sourcezone 12 und die Drainzone 13.

Im Anschluß daran wird der gesamte Halbleiteraufbau mit einer Passivierungsschicht 6 aus z.B. SiO₂ abgedeckt und in derselben photolithographisch ein Graben 7 erzeugt. Wände und Randbereiche desselben werden mit einer zweiten Haftschicht 10 versehen und anschließend das Dielektrikum 8 und die darauf angeordnete Elektrodenschicht 9 abgeschieden und photolithographisch entsprechend strukturiert.

Als letzter Schritt werden dann die Anschlüsse für die aktiven Zonen, die Gate-Elektrode und die Kontaktschicht 5 ebenfalls nach der üblichen photolithographischen Methode erzeugt und zur Verbindung die herkömmliche Metallisierung vorgenommen.

Besteht bei diesem Verfahren die Haftschicht 4 aus Pt, Ti oder TiW so bildet sich mit dem darunterliegenden Silicium der Drainzone 12 ein Silicid aus, das als Kontaktvermittler wirkt.

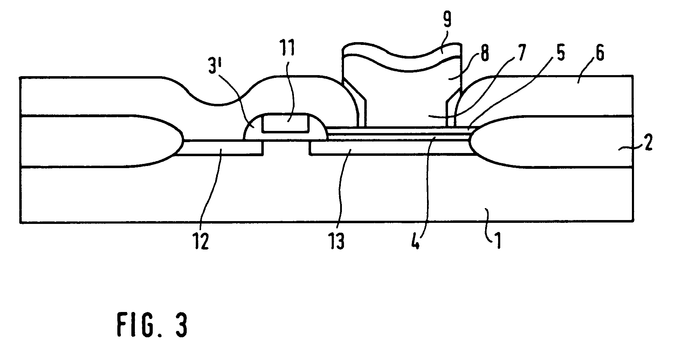

Ein drittes Ausführungsbeispiel der Erfindung ist in Fig.3 dargestellt. Es ist darin der mit einer Feldoxidschicht 2 versehene Halbleiterkörper 1 gezeigt. In der durch die Feldoxidschicht 2 gebildeten Umrandung sind die Source-Zonen 12 und die Drainzone 13 in den Halbleiterkörper eingelassen. Die Gate-Elektrode 11 ist vom Kanal zwischen den beiden aktiven Zonen und von diesen durch eine dünne Oxidschicht getrennt, die seitlich verstärkt die Gate-Elektrode 11 als Isolierschicht 3′ umschließt. Zwischen dem einen Berandungsteil der Feldoxidschicht 2 und dem Hand der gegen ihn gerichteten Isolierschicht 3′ ist über der Drain-Elektrode eine Doppelschicht aus einer ersten Haftschicht 4 und einer Kontaktschicht 5 angeordnet. Die gesamte Struktur ist mit einer Passivierungsschicht 6 abgedeckt, die im Bereich der Doppelschicht einen Graben 7 aufweist, dessen Wände und Ränder mit einer zweiten Haftschicht 10 überzogen sind, auf denen das Dielektrikum 8 aufsitzend bis zur Kontaktschicht 5 reicht. Die Oberfläche des Dielektrikums 8 ist mit einer Elektrodenschicht 9 überzogen. Aus Gründen der Übersichtlichkeit fehlen hier wiederum die entsprechenden Anschlüsse der aktiven Zonen und der Kontaktschicht 5 (Metallisierung).

Zur Herstellung der in Fig.3 gezeigten Struktur wird von einem Halbleiterkörper 1 ausgegangen, auf dessen Oberfläche unter Ausbildung eines Freiraumes eine Feldoxidschicht 2 erzeugt wird. Im Bereich der freigelassenen Oberfläche wird zunächst in üblicher Weise mittels Photolithographietechnik die durch eine dünne Oxidschicht von dieser getrennte Gate-Elektrode 11 erzeugt und anschließend nach Herstellung von Öffnungen mittels herkömmlicher Technik, wie z.B. durch Ionenimplantation mit nachfolgender Diffusion, die Source- und Drain-Zonen 12, 13 hergestellt. Auf der Oberfläche der Drainzone 13, deren Oberfläche zuvor mit z.B. Ti zusammen mit der Oberfläche der Gateelektrode 11 siliciert worden ist, wird dann eine Doppelschicht aus einer aufliegenden Haftschicht 4 und einer darüberangeordneten Kontaktschicht 5 abgeschieden. Im nächsten Schritt wird dann die ganze Oberfläche mit einer Passivierungsschicht 6 abgedeckt und anschließend unter Zuhilfenahme herkömmlicher Photolithographie und Ätztechniken die Passiverungsschicht 6 im Bereich der Doppelschicht unter Ausbildung des Grabens 7 entfernt. Wände und Ränder des Grabens 7 werden mit einer zweiten Haftschicht 10 belegt und daraufhin das Dielektrikum 8 mit auf ihm aufliegender Elektrodenschicht 9 abgeschieden und strukturiert. Zur Vervollständigung werden dann die in der Fig.3 nicht gezeigten Anschlüsse der Gate-Elektrode und der Source- und Drainzone 12, 13 und der Kontaktschicht 5 erstellt.

Anzumerken ist noch, daß die Eletrodenschicht 9 direkt mit den Kontaktbereichen der Source- und Drainzonen 12, 13 des Halbleiterbauelements oder mit einem freibeweglichen Massekörper verbunden sein kann. Ferner ist zu erwähnen, daß die Kontaktschicht 5 eine erste Verdrahtungsebene für Speicherzellen bilden kann.

In dem Fall, daß Titan als Haftschicht 4 eingesetzt wird, kann es sich als zweckmäßig erweisen, eine Stoppschicht an der Grenzfläche zur Kontaktschicht 5 anzuordnen, um eine gegenseitige Beeinflußung zu vermeiden.

## Patentansprüche

1. Kapazitätsstruktur für MOS-FET-Halbleiterspeicher, die auf dem fertigen Halbleiterkörper (1) angeordnet ist, bestehend aus
- einer auf dem Halbleiterkörper (1) aufgebrachten Haftschicht (4) mit einer darauf abgelagerten, bis 1000°C gegen Sauerstoffeinwirkung stabilen Kontaktschicht (5), die bis auf einen Graben (7) von einer auf dem Halbleiterkörper (1) angeordneten Passivierungsschicht (6) abgedeckt ist,
- einem in dem Graben (7) auf der Kontaktschicht (5) aufsitzenden Dielektrikum (8) aus Keramik, das von einer Elektrodenschicht (9) bedeckt ist und über eine zweite Haftschicht (10) auf der Passivierungsschicht (6) überlappend aufliegt.

2. Kapazitätsstruktur nach Anspruch 1, dadurch gekennzeichnet, daß die Haftschicht (4) auf einer den Halbleiterkörper (1) bedeckenden Isolierschicht (3) im Abstand zur einer der aktiven Zonen (12, 13) angeordnet ist.

3. Kapazitätsstruktur nach Anspruch 2, dadurch gekennzeichnet, daß die Isolierschicht (3) aus Phosphorsilikatglas und die Haftschicht (4) aus TiW, Ti, TiN oder TiO2 besteht.

4. Kapazitätsstruktur nach Anspruch 1, dadurch gekennzeichnet, daß die Haftschicht 4 aus Titan besteht und eine Stoppschicht an der Grenzfläche zur Kontaktschicht (5) aufweist.

5. Kapazitätsstruktur nach einem Ansprüche 1 bis 4, dadurch gekennzeichnet, daß die Kontaktschicht (5) und die Elektrodenschicht (9) jeweils aus einem leitfähigem Oxyd wie Indium-Zinn-Oxyd oder einem Metall wie Pd oder Pt bestehen.

6. Kapazitätsstruktur nach einem der Ansprüche 1 bis 5, dadurch gekennzeichnet, daß die Elektrodenschicht (9) direkt mit dem Kontaktbereich der Source- und Drainzonen (12,13) des Halbleiterbauelements verbunden ist.

7. Kapazitätsstruktur nach einem der Ansprüche 1 bis 5, dadurch gekennzeichnet, daß die Kontaktschicht (5) eine erste Verdrahtungsebene für Speicherzellen bildet.

8. Kapazitätsstruktur nach einem der Ansprüche 1 bis 5, dadurch gekennzeichnet, daß die Elektrodenschicht (9) mit einem frei beweglichen Massekörper verbunden ist.

9. Kapazitätsstruktur nach einem der Ansprüche 1 bis 8, dadurch gekennzeichnet, daß die Haftschicht (10) ein Isolator ist.

10. Kapazitätsstruktur nach einem der Ansprüche 1 bis 9, dadurch gekennzeichnet, daß das keramische Material mit Lanthan dotiertes Blei-Zirkon-Titanat ist.

## Claims

1. A capacitance structure for MOSFET semiconductor memories which is disposed on the finished semiconductor substrate (1) and consists of
- an adhesion layer (4) deposited on the semi conductor substrate (1) and covered by a contact layer (5) which is stable to the action of oxygen up to 1000°C and is covered, with the exception of a trench (7), by a passivating layer (6) disposed on the semiconductor substrate (1), and
- a dielectric (8) of ceramic which rests on the contact layer (5) in the trench (7), is covered by an electrode layer (9), and overlaps the passivating layer (6) vi a a separating second adhesion layer (10).

2. A capacitance structure as claimed in claim 1, characterized in that the adhesion layer (4) is disposed, in spaced relationship from one of the active regions (12, 13), on an insulating layer (3) covering the semiconductor substrate (1).

3. A capacitance structure as claimed in claim 2, characterized in that the insulating layer (3) is made of phosphosilicate glass, and that the adhesion layer (4) is made of TiW, Ti, TiN, or TiO₂.

4. A capacitance structure as claimed in claim 1, characterized in that the adhesion layer (4) is made of titanium, and that a blocking layer is provided at its interface to the contact layer (5).

5. A capacitance structure as claimed in any one of claims 1 to 4, characterized in that the contact layer (5) and the electrode layer (9) are made of a conductive oxide, such as indium-tin oxide, or a metal, such as Pd or Pt.

6. A capacitance structure as claimed in any one of claims 1 to 5, characterized in that the electrode layer (9) is connected directly to the contact areas of the source and drain regions (12, 13) of the semiconductor device.

7. A capacitance structure as claimed in any one of claims 1 to 5, characterized in that the contact layer (5) forms a first wiring level for memory cells.

8. A capacitance structure as claimed in any one of claims 1 to 5, characterized in that the electrode layer (9) is connected to a freely movable grounding body.

9. A capacitance structure as claimed in any one of claims 1 to 8, characterized in that the adhesion layer (10) is an insulator.

10. A capacitance structure as claimed in any one of claims 1 to 9, characterized in that the ceramic material is lead lanthanum zirconate titanate.

## Revendications

1. Structure à capacité pour des mémoires à semiconducteurs MOS-FET, qui est disposée sur le corps semiconducteur terminé (1), constituée par
- une couche adhésive (4) déposée sur le corps semiconducteur (1) et sur laquelle est déposée une couche de contact (5), qui est stable jusqu'à 1000°C vis-à-vis de l'action de l'oxygène et qui est recouverte, jusqu'au niveau d'un sillon (7), par une couche de passivation (6) disposée sur le corps semiconducteur (1),
- un diélectrique (8) formé d'une céramique et qui est disposé dans le sillon (7) sur la couche de contact (5), est recouvert par une couche formant électrode (9) et s'applique en chevauchement sur la couche de passivation (6), moyennant l'interposition d'une seconde couche adhésive (10).

2. Structure à capacité selon la revendication 1, caractérisée en ce que la couche adhésive (4) est disposée sur une couche isolante (3), qui recouvre le corps semiconducteur (1), à distance de l'une des zones actives (12, 13).

3. Structure à capacité selon la revendication 2, caractérisée en ce que la couche isolante (3) est réalisée en un verre aux phosphosilicates et que la couche adhésive (4) est formée de TiW, Ti, TiN ou TiO₂.

4. Structure à capacité selon la revendication 1, caractérisée en ce que la couche adhésive (4) est constituée par du titane et possède une couche d'arrêt au niveau de l'interface avec la couche de contact (5).

5. Structure à capacité selon l'une des revendications 1 à 4, caractérisée en ce que la couche de contact (5) et la couche formant électrode (9) sont constituées respectivement par un oxyde conducteur tel que de l'oxyde d'indium et d'étain ou par un métal tel que Pd ou Pt.

6. Structure à capacité selon l'une des revendications 1 à 5, caractérisée en ce que la couche formant électrode (9) est reliée directement à la région de contact des zones de source et de drain (12, 13) du composant à semiconducteurs.

7. Structure à capacité selon l'une des revendications 1 à 5, caractérisée en ce que la couche de contact (5) forme un premier plan de câblage pour des cellules de mémoire.

8. Structure à capacité selon l'une des revendications 1 à 5, caractérisée en ce que la couche formant électrode (9) est reliée à un corps de masse librement mobile.

9. Structure à capacité selon l'une des revendications 1 à 8, caractérisée en ce que la couche adhésive (10) est un isolant.

10. Structure à capacité selon l'une des revendications 1 à 9, caractérisée en ce que le matériau céramique est du titanate de plomb et de zircon, dopé par du lanthane.
